# EUROPEAN PATENT APPLICATION

(11) **EP 2 933 593 A1**
(43) Date of publication of application: **21.10.2015**
(21) Application number: 13863431.6
(22) Date of filing: 09.12.2013
(51) Int. Cl.: F28D 15/02

(54) **COOLING DEVICE**

(30) Priority: 11.12.2012 JP 2012270853
(71) Applicant: Furukawa Electric Co., Ltd., Chiyoda-ku Tokyo 100-8322 (JP)
(72) Inventor: ISEMURA Masakazu, Tokyo 100-8322 (JP); OKAMOTO Tsuyoshi, Tokyo 100-8322 (JP); YAMADA Hiroshi, Tokyo 100-8322 (JP); KONISHI Kazuhiro, Tokyo 100-8322 (JP); SANO Masaki, Tokyo 100-8322 (JP)
(74) Representative: Jordan, Volker Otto Wilhelm
(86) International application number: PCT/JP2013/083004
(87) International publication number: WO 2014/092057

(57) **Abstract**

Provided is a cooling apparatus having a heat dissipation fin disposed also at a bent portion of a heat pipe near the heat receiving block and being configured to evenly receive a wind by all the heat dissipation fins, to thereby improve cooling capacity. The cooling apparatus (10) includes a heat receiving block (2) thermally connected to electronic components (H1, H2) constituting heating elements, a heat pipe (3) that is provided to stand on a surface of the heat receiving block (2) and configured to receive heat from the heat receiving block (2) and to transport heat, and a plurality of fins (4) attached to the heat pipe (3). The fins (4) include a first fin group (41) disposed at a straight portion (34) and a second fin group (42) disposed at a bent portion (33) of the heat pipe (3).

## Description

### Technical Field

The present invention relates to a cooling apparatus that cools a heating element, and particularly relates to a cooling apparatus that cools, by air-cooling, electrical components such as power conversion devices installed in moving objects such as railway vehicles, aircrafts and marine vessels.

### Background Art

A moving object such as a railway vehicle is provided with a power control apparatus for controlling a drive motor or the like, the power control apparatus including power devices such as IGBTs and other electronic components disposed in a power control housing. Since these electronic components generate heat due to heat loss, a cooling apparatus is attached to a heating element to efficiently cool the installed electric components by utilizing a wind caused by forced-air cooling or by a movement of the vehicle.

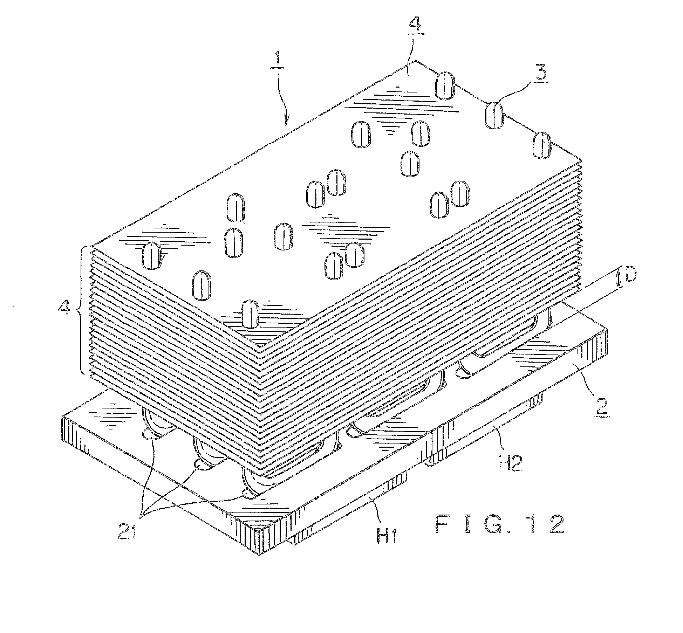

An example of a conventional cooling apparatus is shown in FIG. 12. In FIG. 12, a cooling apparatus 1 includes a heat receiving block 2 whereto electronic components H1 and H2, which are heating elements, are attached, a heat pipe 3 soldered to the heat receiving block 2, and a heat dissipation fin group 4 attached to the heat pipe 3. More specifically, as shown in FIG. 12, a general configuration is obtained by, for example, soldering a bottom portion of the heat pipe 3 to the heat receiving block 2 for attaching a heater element, the heat receiving block 2 corresponding to the heat receiving section and having an elongated groove 21 for securing the heat pipe 3 on one side, and press fitting the heat dissipation fin 4 having a circular burring portion to the soldered heat pipe 3.

With the conventional cooling apparatus described above, in order to improve cooling efficiency of the entire cooling apparatus without increasing the number of heat dissipation fins installed or without increasing an air-capacity of the cooling air, there have been various efforts such as, for example, varying fin pitches on an upstream side of the wind and on a downstream side of the wind (for example, see Patent Document 1). Also, as shown in FIG. 12, the heat pipe 3 having a U-shape (or L-shape) when viewed from the side may be used for improving a cooling effect.

### Document List

### Patent Document(s)

Patent Document 1: Japanese Laid-Open Patent Publication No. 2011-181882

### Summary of Invention

### Technical Problem

For a conventional cooling apparatus, a heat receiving block having a reduced thickness may be required for the purpose of lightweighting of the cooling apparatus. In such a case, as shown in FIG. 12, an R-configuration of a bent portion of a U-shaped or an L-shaped heat pipe appears above the heat receiving block near a portion where the heat receiving block and the heat pipe are joined.

In general, a heat dissipation fin is provided with a burring hole at a position corresponding to a position where the heat pipe is provided, and the heat pipe is press-fitted into this hole to thereby pressure bond the heat dissipation fin and the heat pipe. However, in a case where the bending portion of the U-shaped or L-shaped heat pipe appears above the heat receiving block, it is difficult to tightly attach the bending part of the heat pipe to the hole in the heat dissipation fin. In a case where no fins are disposed at a bending portion of the heat pipe which is near the heat receiving block, such region becomes a dead space D. Since no fins are disposed, this dead space D cannot be expected to contribute to heat dissipation. Furthermore, since wind escapes through the dead space D, it is not possible to evenly receive the wind by all the fins, and there is a concern that cooling capacity may decrease.

The present invention is suggested to solve the problems of the prior art as described above, and it is an object of the present invention to provide a cooling apparatus having a heat dissipation fin disposed at a bent portion of a heat pipe near the heat receiving block and being configured to evenly receive a wind by all of the heat dissipation fins, to thereby improve cooling capacity.

### Solution to Problem

In order to achieve the above mentioned object, the first invention is characterized by including a heat receiving block that is thermally connected to a heating element, a heat pipe that is provided to stand on a surface of the heat receiving block, the heat pipe being configured to receive heat from the heat receiving block and to transport the heat, and a plurality of fins attached to the heat pipe, the heat pipe including a bent portion provided near the heat receiving block and a straight portion formed linearly from the bent portion in a direction away from the heat receiving block, the fins including a first fin group disposed at the straight portion and a second fin group disposed at the bent portion, each fin of the second fin group being provided with a hole having an area equivalent to or greater than a cross section of the bent portion and being thermally connected to the heat receiving block by a connecting member that secures the second fin group to the heat receiving block.

According to the aforementioned aspect, since the second fin disposed at a bent portion of the U-shaped or L-shaped heat pipe is provided with a hole having an area equivalent to or greater than a cross section of the bent portion, a heat dissipation fin can be provided at a bent portion of the heat pipe, which is a portion where it was conventionally difficult to dispose a heat dissipation fin because of the structure. Further, by using a thermally-conductive connecting member such as an aluminum pin or a copper pin to secure the heat dissipation fin and to thermally connect to the heat receiving block, the heat of the heat receiving block can be transferred to the heat dissipation fin via the connecting member. Thereby, by disposing a fin at a part which was conventionally a dead space, cooling capacity can be improved and also a wind does not escape in the vicinity of the bent portion and thus a wind can be evenly received by all the fins. Further, since a heat dissipation fin can be disposed at a part which was conventionally a dead space, it is possible to reduce the number of heat dissipation fins which were disposed opposite the said space of the cooling apparatus and to lower the height of the cooling apparatus.

The second invention is characterized in that, based on the first invention, at least one fin in the first fin group is thermally connected to the heat receiving block by the connecting member.

According to the above-mentioned aspect, at least one fin of the first fin group which is provided at a straight part constituting a straight portion of the heat pipe is also thermally connected to the heat receiving block by a connecting member, separately from the thermal connection to the heat pipe. Whereby, heat of the heat receiving block is absorbed through the connecting member separately from the heat pipe, and the heat is transported to the fin, to thereby improve the heat dissipation performance. Further, the first fin group is also thermally connected to the heat pipe and thus effects are not only those described above. That is, in a case where the cooling apparatus is used under a low temperature environment, a working fluid in the heat pipe may freeze. In this case, heat radiation efficiency is low until the working fluid melts. However, according to the present aspect, heat from the aforementioned connecting member transfers to the heat pipe and accelerates the melting of the working fluid. Consequently, heat radiation efficiency can be increased at an early stage during the start-up of the cooling apparatus under a low temperature environment.

The third invention is characterized in that, based on the first invention, the connecting member is interposed between an outer periphery of the bent portion and an inner periphery of the hole to thermally connect the heat pipe and the second fin group.

In the aforementioned aspect, even for a bent portion, which is a portion where it was conventionally difficult to secure a heat dissipation fin, and even if secured, where it was conventionally difficult to tightly attach, because of the structure, a connecting member is interposed between an inner periphery of a hole provided in each fin of the second fin group and an outer periphery of the bent portion, so that these can be thermally connected. Thereby, by disposing a fin at a portion which used to be conventionally a dead space, cooling capacity can be improved and also a wind does not escape in the vicinity of the bent portion and a wind can be evenly received with all the fins. Further, in a case where the cooling apparatus is used under a low temperature environment, since heat from the connecting member transfers to the heat pipe, melting of the working fluid is accelerated and heat radiation efficiency can be increased at an early stage during a start-up of the cooling apparatus under a low temperature environment.

The fourth invention is characterized in that, based on the third invention, the hole of the second fin group has an elliptical shape, and the connecting member is an elliptic cylindrical body having an outer periphery of substantially the same size as the elliptical shape of the hole and an inner periphery of substantially the same size as an outer periphery of the heat pipe.

According to the aforementioned aspect, the second fin group and the heat pipe can be thermally connected by press-fitting a second fin group to an elliptic cylindrical body, securing the second fin group at an outer peripheral surface of the elliptic cylindrical body, and tightly attaching to the heat pipe at an inner peripheral surface.

The fifth invention of the present invention is based on the third and the fourth invention, the hole of the second fin group is burred, and the second fin group being thermally connected to the connecting member and to the heat pipe wider than a thickness of the fin.

According to the aforementioned aspect, since the hole provided in the second fin group is burred, the heat pipe and the fin can come into contact over a large area even at the bent portion of the heat pipe, and thus the cooling capacity can be improved.

### Effects of Invention

According to the aforementioned invention, since a heat dissipation fin is disposed at a bent portion of a heat pipe near a heat receiving block and all the heat dissipation fins can evenly receive a wind, a cooling apparatus having an improved cooling capacity can be provided.

### Brief Description of Drawings

[FIG. 1] Fig. 1 is an overall perspective view showing a configuration of a cooling apparatus of a first embodiment of the present invention.
[FIG. 2] FIG. 2A is a perspective view and FIG. 2B is a plan view showing a configuration of a part of the cooling apparatus of the first embodiment of the present invention.
[FIG. 3] FIG. 3 is an enlarged perspective view showing a configuration of a part of the cooling apparatus of the first embodiment of the present invention.
[FIG.4] FIG. 4 is a side view showing the configuration of the cooling apparatus concerning the first embodiment of the present invention.
[FIG. 5] FIG. 5 is an overall perspective view showing a configuration of a cooling apparatus of a second embodiment of the present invention.
[FIG. 6] FIG. 6 is an enlarged perspective view showing a part of the configuration of the cooling apparatus of the second embodiment of the present invention.
[FIG. 7] FIG. 7 is an overall perspective view showing a configuration of a cooling apparatus of a third embodiment of the present invention.
[FIG. 8] FIG. 8 is an enlarged perspective view showing a part of the configuration of the cooling apparatus of the third embodiment of the present invention.
[FIG.9] FIG. 9 is an enlarged sectional view showing a part of the configuration of the cooling apparatus of the second embodiment of the present invention.
[FIG. 10] FIG. 10 a schematic block diagram showing conditions of examples of the cooling apparatus of the embodiment of the present invention.
[FIG. 11] FIG. 11 is a table showing the results for examples of the cooling apparatus of the embodiments of the present invention.
[FIG.12] FIG. 12 is a perspective view showing a configuration of the conventional cooling apparatus.

### Description of the Preferred Embodiments

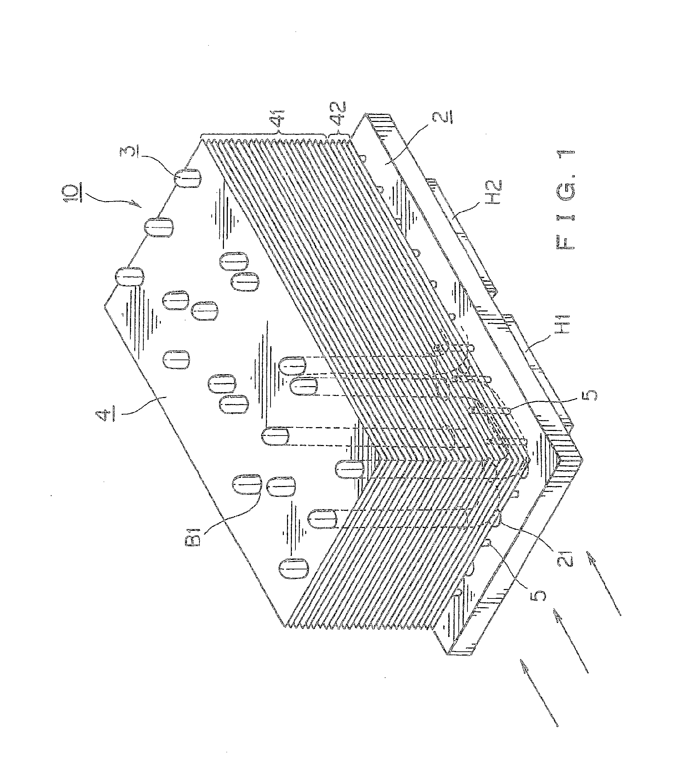

Hereinafter, embodiments of the present invention will be described with reference to FIGS. 1 to 11.

### [1. First Embodiment]

A cooling apparatus 10 of a first embodiment of the present invention includes, as shown in FIG. 1, a heat receiving block 2 thermally connected to electronic components H1 and H2 constituting a heating element, a heat pipe 3 that is provided to stand on a surface of the heat receiving block 2, receives heat from the heat receiving block 2 and transports the heat, and a plurality of fins 4 attached to the heat pipe 3.

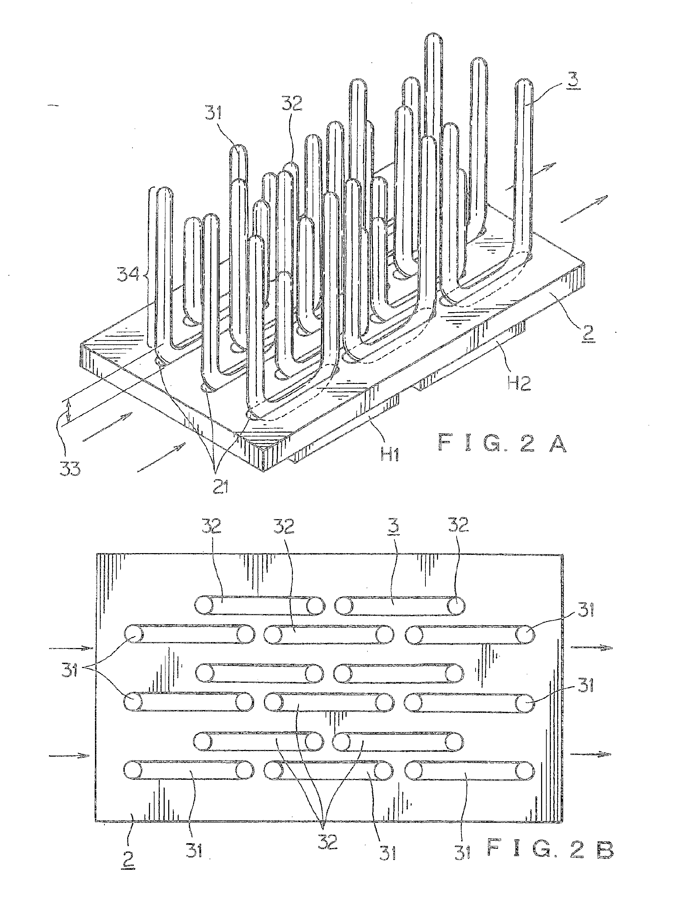

As shown in FIGS. 2A and 2B, the heat receiving block 2 is connected to the electronic components H1, H2 at one face side having a rectangular shape (bottom face side in FIGS. 2A and 2B) and a plurality of heat pipes 3 are provided to stand on the other face side (plan view side in FIGS. 2A and 2B). More specifically, on the other face side of the heat receiving block 2, a plurality of elongated grooves 21 for securing the plurality of heat pipes 3 are provided with their longitudinal axis directions being aligned with a wind direction shown by arrows in FIGS 2A and 2B. A U-shaped bottom end side of the heat pipe 3 is embedded into the elongated groove 21 and secured by methods such as soldering or swaging.

As has been described above, the heat pipe 3 is a U-shaped heat pipe, and in the present embodiment, as shown in FIGS. 2A and 2B, two types including a long HP 31 and a short HP 32 are disposed on the heat receiving block 2. The heat pipe 3 is U-shaped, and includes a bent portion 33 provided near the heat receiving block 2 and a straight portion 34 formed linearly from the bent portion 33 in a direction away from the heat receiving block.

Note that, in the present embodiment, the bent portion 33 does not refer to an entire part constituting a U-shaped bend of the heat pipe 3, but rather refers to a portion of the heat pipe 3 from a part where the heat pipe 3 attached to the heat receiving block 2 appears above a plane of the heat receiving block 2 to a part up to the straight portion as shown in FIG. 2A. In the present embodiment, only an example using a U-shaped heat pipe is shown. However, in the present invention, any heat pipe having a straight portion and a bent portion such as an L-shape heat pipe is applicable.

As shown in FIG. 1, the fins 4 are constituted by a first fin group 41 disposed at the straight portion 34 of the heat pipe 3 and a second fin group 42 disposed at the bent portion 33. In the present embodiment, four fins on a heat receiving block 2 side are constituted as the second fin group 42. Note that the second fin group 42 is not limited to four fins.

The first fin group 41 has a configuration similar to that of the prior art shown in FIG. 12, and is positioned and secured at a predetermined position by providing a plurality of circular burring portions B1 on a surface of each fin and press-fitting the straight portion 34 of the heat pipe 3 into each of the circular burring portions B1.

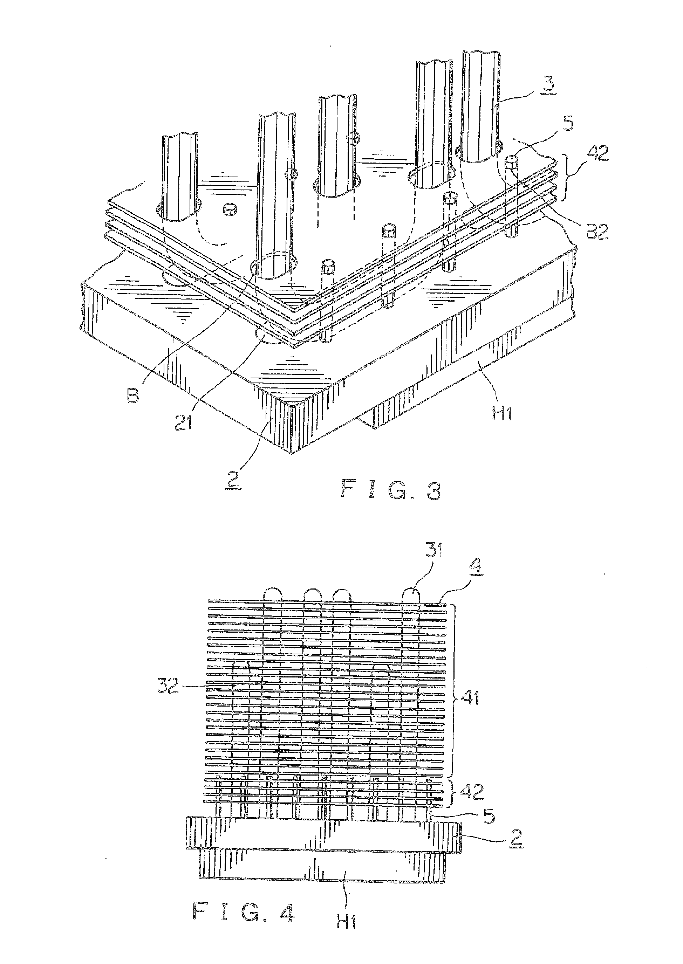

As shown in an enlarged view of FIG. 3, the second fin group 42 has, on its surface, at positions corresponding to the heat pipe 3, a plurality of clearance holes B each having an elliptic shape having an area of about the same size as a maximum area of a cross-section of the bent portion 33 of the heat pipe 3. The clearance hole B is configured such that the bent portion 33 can be inserted through and each fin constituting the second fin group 42 can be disposed as a stack, and in this case, it may or may not be in contact with the heat pipe 3. That is, thermal exchanges by the contact may or may not exist. Note that, in FIG. 3, illustration of the first fin group 41 is omitted for the sake of convenience of explanation.

In addition to the clearance holes B, the second fin group 42 is provided with a burring portion B2 at a position of each fin corresponding to a pin 5 on the heat receiving block 2. By press-fitting the pin 5 through the burring portion B2, the second fin group 42 is secured to the heat receiving block 2 and thereby thermally connected to the heat receiving block 2 and the pin 5. The pin 5 is disposed to correspond to the arrangement of the heat pipes 3, and, for example, in the present embodiment, ten pins 5 are arranged in a row along a wind direction and seven such rows are provided (see FIGS. 3 and 4). Also, it is preferable that the pin 5 is made of aluminum or copper having a high thermal conductivity.

According to the cooling apparatus 10 of the present embodiment configured as described above, there are two heat transport paths as described below. That is, the two heat transport paths of the cooling apparatus 10 are a route along which heat is transferred from the electronic components H1, H2, serving as a heat source, to the first fin group 41 through a heat transportation from a heat receiving side to a heat dissipation side of the heat pipe 3 via the heat receiving block 2, and a route along which heat is transferred from the electronic components H1, H2 to the pin 5 via the heat receiving block 2 and transferred from the pin 5 to the second fin group 42.

According the cooling apparatus 10 described above, the second fin group 42 can be provided even at a bent portion 33, which is a portion where it was conventionally difficult to secure a heat dissipation fin, and even if secured, where it was difficult to tightly attach because of the structure. This is achieved by providing a plurality of clearance holes B, each having an area of about the same size as a maximum area of a cross-section of the bent portion 33, on a surface of the second fin group 42, and by using the pin 5 constituted by a thermally-conductive connecting member such as aluminum or copper to secure the heat dissipation fin 4 and to thermally connect to the heat receiving block 4.

In this manner, with the pin 5, heat of the heat receiving block 2 can be transferred to the heat dissipation fin 4 without passing through the heat pipe 3. Thus, by disposing a heat dissipation fin 4 at a portion which used to be conventionally a dead space, cooling capacity can be improved. Further, by disposing the second fin group 42 at the bent portion 33, the wind does not escape in the vicinity of this part, and the wind can be evenly received by all the fins 4 including the first fin group 41.

### [2. Second Embodiment]

A cooling apparatus 20 according to the second embodiment of the present invention is constituted based on the configuration of the first embodiment, and has a structural characteristic feature in that a third fin group 43 formed at a straight portion of the heat pipe 3 is provided as a part of the first fin group 41. In the following description, the configuration of the third fin group 43 and, in relation to this configuration, a configuration which is different from that of the first embodiment will be described, and description on constituent elements that are similar to those of the first embodiment will be omitted.

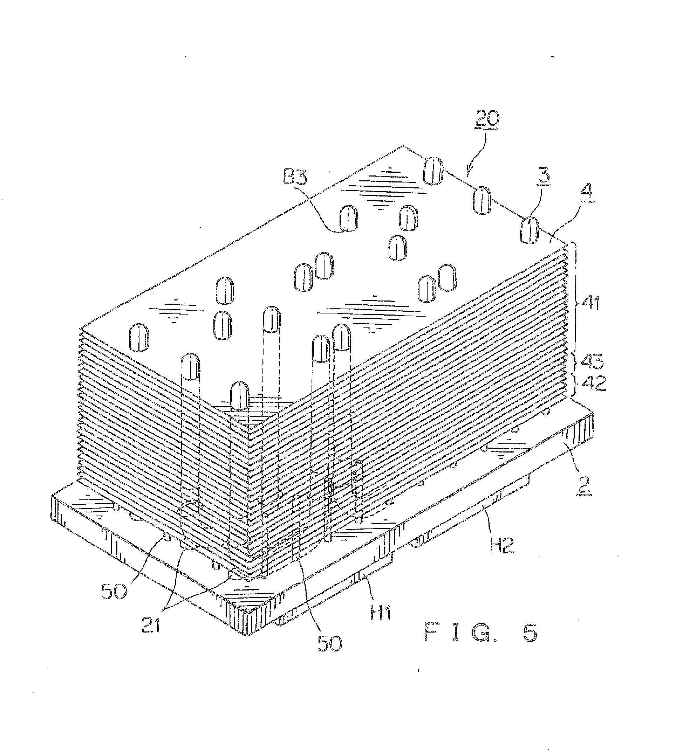

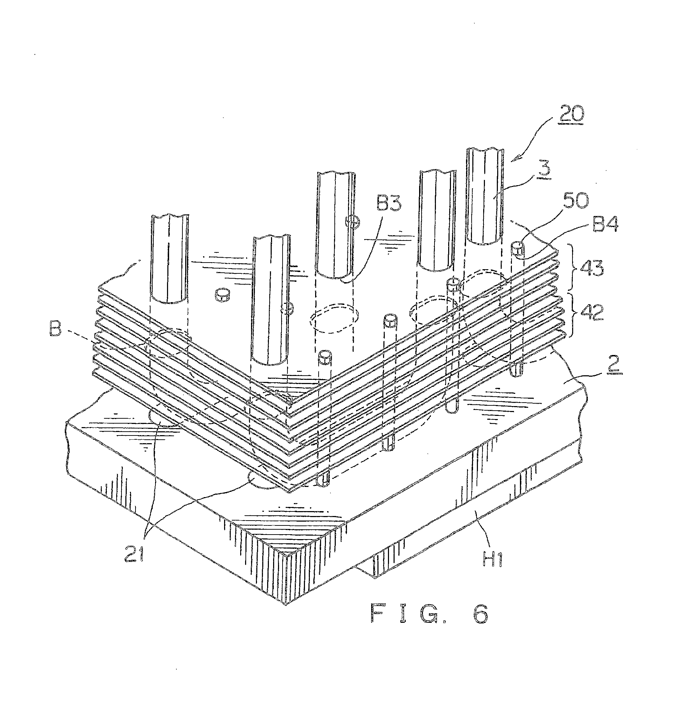

As shown in FIG. 5, in the cooling apparatus 20, the fins 4 are constituted by three fin groups including the first fin group 41, the second fin group 42 and the third fin group 43. As shown in an enlarged view of FIG. 6, the third fin group 43 is provided at a side above the second fin group 42 in the drawings, or a side farther from the heat receiving block 2, and between the second fin group 42 and the first fin group 41. It is to be noted that, the first fin group 41 and the second fin group 42 have a configuration similar to that of the first embodiment, except that the number of fins in the first fin group 41 is different.

In the present embodiment, similarly to the second fin group 42, the third fin group 43 includes four fins. Unlike the second fin group 42, the third fin group 43 is formed at the straight portion 34 of the heat pipe 3 (see FIG. 2A). Accordingly, the third fin group 43 has a plurality of circular burring portions B3 on a surface of each fin. Further, the third fin group 43 has, in addition to the circular burring portion B3, a burring portion B4 whereto the pin 50 that is longer than the configuration in the first embodiment is press-fitted similarly to the second fin group 42, the burring portion B4 being provided at a position corresponding to the pin 50 on the heat receiving block 2.

That is, the third fin group 43 is secured by being tightly attached to a predetermined position of the heat pipe 3 by press-fitting the straight portion 34 of the heat pipe 3 through the circular burring portion B3. Also, the third fin group 43 is positioned and secured by press-fitting the pin 50 into the burring portion B4. Thereby, the third fin group 43 is thermally connected to both the heat receiving block 2 and the pin 50.

Note that in the present embodiment, as has been described above, the pin 50 is configured to have a length longer than the length of pin 5 of the first embodiment by a length corresponding to four fins 4.

Heat transport paths in the cooling apparatus 20 of the present embodiment having the aforementioned configuration are as follows. That is, the two heat transport paths of the cooling apparatus 20 are a route along which heat is transferred from the electronic components H1, H2, serving as a heat source, to the first fin group 41 and the third fin group 43 through a heat transportation from a heat receiving side to a heat dissipation side of the heat pipe 3 via the heat receiving block 2 and a route along which heat is transferred from the electronic components H1, H2 to the pin 50 via the heat receiving block 2 and transferred to the second fin group 42 and the third fin group 43 via the pin 50.

The cooling apparatus 20 of the configuration described above has the following effects in addition to the effects of the cooling apparatus 10 of the first embodiment. That is, separately from a thermal connection with the heat pipe 3, the third fin group 43 provided at the straight portion 34 of the heat pipe 3 is thermally connected to the heat receiving block 2 by the pin 50 which is a connecting member.

Thereby, heat of the heat receiving block 2 is absorbed through the pin 50 separately from the heat pipe 3 and heat is transported to the third fin group 43. Thereby, heat dissipation performance can be improved.

Also, the third fin group 43 is thermally connected to heat pipe 3 and thus has, in addition to the aforementioned effects, remarkable effects as described below. That is, in a case where the cooling apparatus 20 is used under a low temperature environment (e.g., a condition of -20 °C. The same applies below), a working fluid in the heat pipe freezes. In this case, generally, the heat pipe merely functions as a copper tube until the working fluid melts, and heat radiation efficiency is lower than the original function. In this regard, in the present embodiment, since heat from the aforementioned pin 50 transfers to the heat pipe 3, the melting of the frozen working fluid is accelerated. In this manner, according to the cooling apparatus 20, heat radiation efficiency can be improved at an earlier stage particularly during the start-up of the cooling apparatus under a low temperature environment.

### [3. Third Embodiment]]

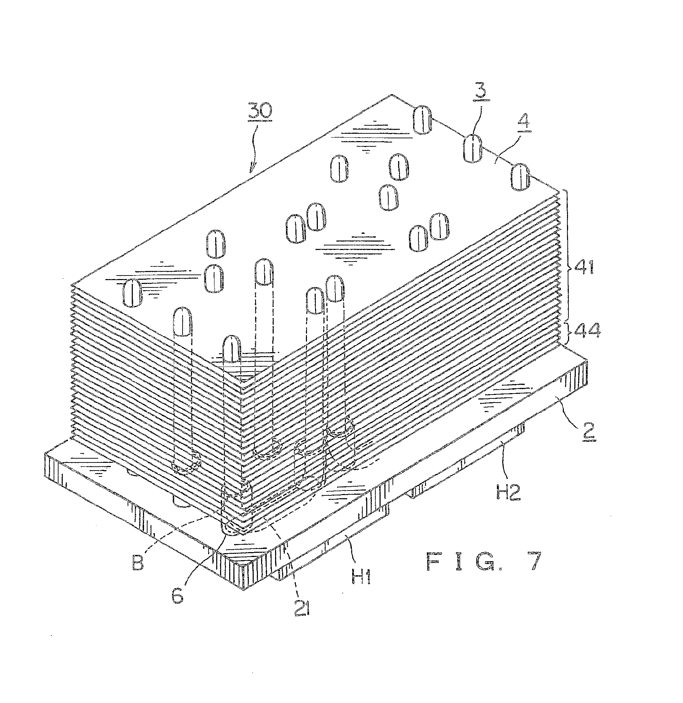

A cooling apparatus 30 according to the third embodiment of the present invention is configured such that thermal connection and positioning-securing between the second fin group 42 and the heat receiving block 2, which used to be provided by the pin 5 in the configuration of the first embodiment, are provided by an elliptic cylindrical member 6. As shown in FIG. 7, a fourth fin group 44 is used instead of the second fin group 42 in the first embodiment. Note that other configuration is similar to that of the first embodiment.

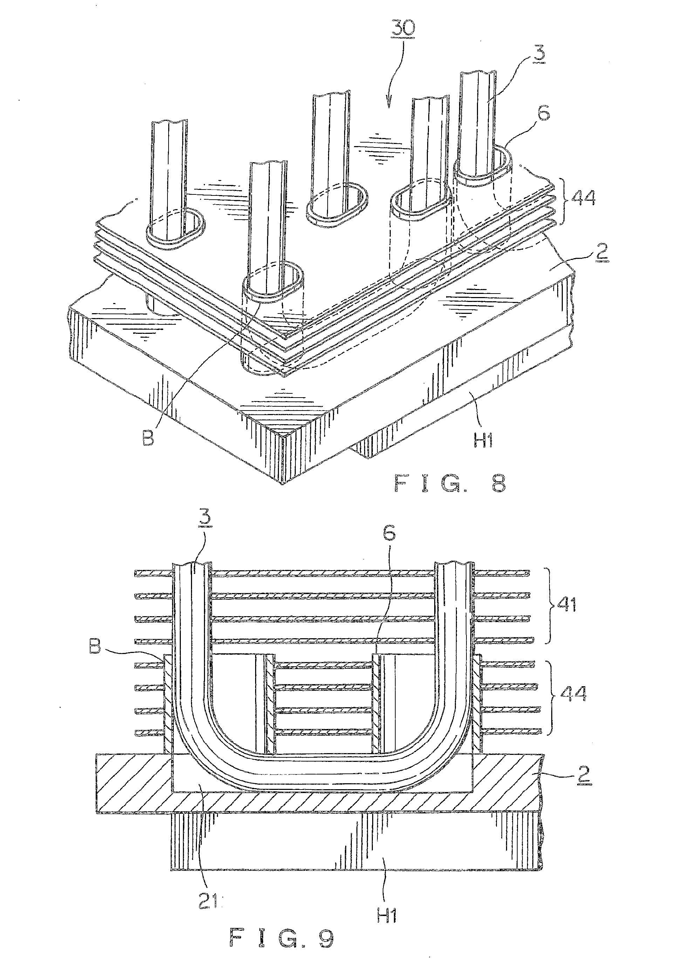

As shown in an enlarged view of FIG. 8, the fourth fin group 44 has a plurality of clearance holes B at positions corresponding to the heat pipes 3, each hole B having an area of about the same as a maximum area of a cross-section of the bent portion 33 of the heat pipe 3. The clearance hole B is provided on a surface of each fin of the second fin group 42 by burring. Similarly to the case of the first embodiment, the clearance hole B is configured such that the bent portion 33 can be inserted through and each fin constituting the second fin group 42 can be disposed as a stack. Note that the fourth fin group 44 is not provided with the burring portion B2 provided on the second fin group 42 through which the pin 5 is press-fitted.

The elliptic cylindrical member 6 is a cylindrical body having an elliptic cross-sectional shape, and has an outer periphery which is slightly greater than an inner periphery of the aforementioned clearance hole B, and an inner periphery thereof is equivalent to an outer periphery of the heat pipe 3. The elliptic cylindrical member 6 is configured to have a height slightly higher than a height of the stacked fins of the fourth fin group 44 and equivalent to a range of height of the bent portion 33 of the heat pipe 3. Note that, similarly to the pin 5, the elliptic cylindrical member 6 is preferably formed of a material having a high thermal conductivity such as aluminum or copper.

With the cooling apparatus 30 of the configuration described above, first, with the heat pipe 3 being positioned in the elongated groove 21, the heat pipe 3 is inserted through a hollow part of the elliptic cylindrical member 6, and, as shown in a cross sectional view of FIG. 9, positioned in such a manner that an inner peripheral surface of the elliptic cylindrical member 6 tightly attaches to an outer periphery of the heat pipe 3. Then, the heat pipe 3 is secured to the heat receiving block 2 by soldering or swaging, and the elliptic cylindrical member 6 is soldered to the heat receiving block 2. At this time, the hollow part of the elliptic cylindrical member 6 may remain hollow, or a top face and a bottom face may be closed and the hollow part may be evacuated, and further, it may be filled with solder or the like.

In the embodiment described above, as an example of the connecting member between the fourth fin group 44 and the heat pipe 3, it is shown that the elliptic cylindrical member 6 is a cylindrical body. However, in the present invention, any shape may be employed as long as it is a member interposed between the outer periphery of the bent portion 33 of the heat pipe 3 and the inner periphery of the clearance hole B provided in the fourth fin group.

With the cooling apparatus 30 of the present embodiment described above, even a bent portion at which it was conventionally difficult to secure a heat dissipation fin and even if secured, it was difficult to tightly attach because of the structure, by interposing the elliptic cylindrical member 6 corresponding to the shape of the clearance hole B as a connecting member between the clearance hole B provided in the fourth fin 44 and the heat pipe 3, the receiving block 2, the heat pipe 3, the elliptic cylindrical member 6 and the fourth fin 44 can be thermally connected.

Thereby, by disposing the fourth fin 44 at a portion which used to be conventionally a dead space, cooling capacity can be improved and also wind does not escape in the vicinity of the bent portion 33 and wind can be evenly received with all the fins.

Further, since heat from the heat receiving block 2 can be transferred to the heat pipe 3 via the elliptic cylindrical member 6, even in a case where the cooling apparatus 30 is used under a low temperature environment and the working fluid inside the heat pipe 3 is frozen, heat is transferred from the heat receiving block 2 to the heat pipe 3 via the elliptic cylindrical member 6, the melting of the working fluid is accelerated and heat radiation efficiency can be increased at an early stage during a start-up of the cooling apparatus under a low temperature environment.

### EXAMPLES

Analysis results of cooling efficiency of the cooling apparatuses 10, 20 and 30 of each of the embodiments described above will be described in comparison with the conventional cooling apparatus 1. As the prior art example, the cooling apparatus 1 shown in FIG. 12 as described above was used, and, as the embodiments of the present invention, the cooling apparatus 10 in the first embodiment shown in FIG. 1, the cooling apparatus 20 in the second embodiment shown in FIG. 5 and the cooling apparatus 30 in the third embodiment shown in FIG. 7 were compared.

In the cooling apparatuses used in the analysis, as the common configuration, an aluminum block was used as the heat receiving block 2, which aluminum block having a wind direction width of 430 mm, a longitudinal direction width, which is in a direction perpendicular to the wind direction, of 230 mm, and a thickness of 22.5 mm. The heat pipe 3 has a diameter of 15.88 mm, and fifteen in total were used as shown in FIGS. 2A and 2B. The heat pipes 3 are arranged such that six rows are arranged along the wind direction shown by arrows in FIG. 2B with long HPs 31 and short HPs 32 being arranged in combination as appropriate. A maximum height from a surface of the heat receiving block 2 to an end of the long HP 31 of the heat pipe 3 in the side view as shown in FIG. 4 was 205 mm. The short HPs 32 are provided in the cooling apparatuses 20 and 30 of the second and third embodiments, for the purpose of causing the working fluid in the heat pipe 3 to melt at an early stage during the start-up to make it function as a heat pipe. That is, the working fluid melts earlier in the short HP 32, since it has a smaller volume as compared to the long HP 31.

Copper fins were used as the fins 4 in each of the first fin group 41, the second fin group 42 and the third fin group 43, each copper fin having a wind direction width of 400 mm, a longitudinal direction width, which is a direction perpendicular to the wind direction, of 200 mm, a thickness of 9.5 mm, and an arrangement pitch of the fins of 6 mm.

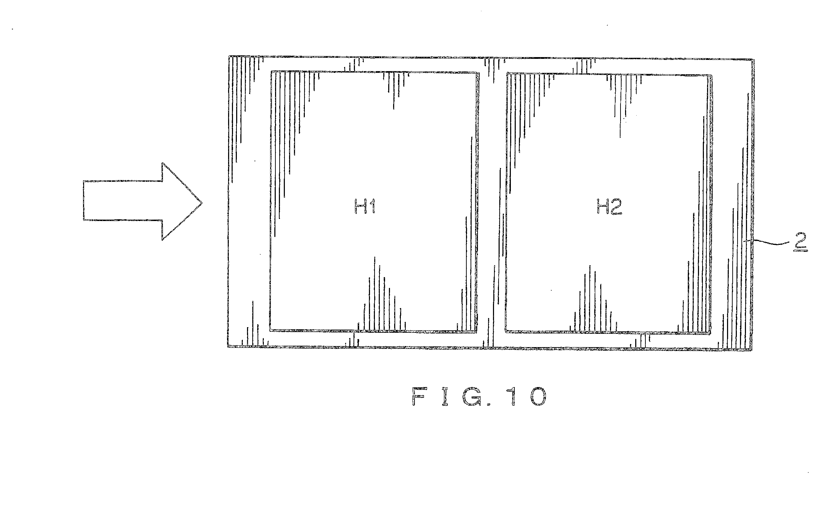

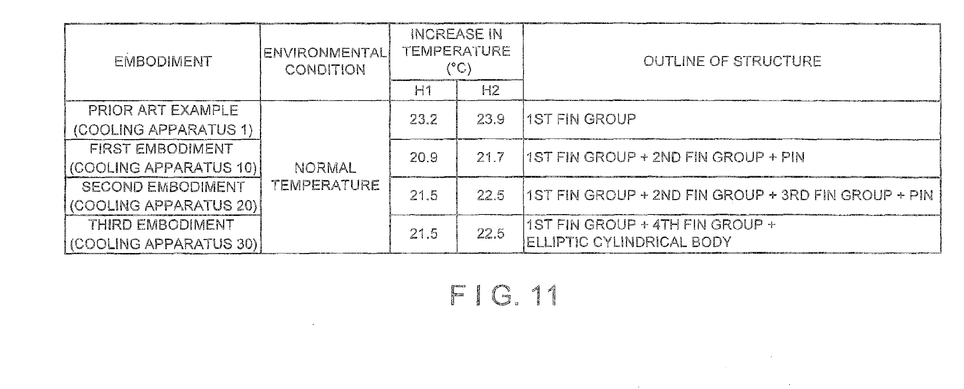

With the configuration of the cooling apparatus described above and using H1 and H2 as heat sources attached to the heat receiving block 2 as shown in a plan view of FIG. 10, an analysis was carried out under a condition in which a heat input to each of H1 and H2 was 1000 W, each of the cooling apparatuses was placed in a box having a wind direction length of 2430 mm, a width in a direction perpendicular to the wind direction of 230 mm, and a height of 205 mm, and air was blown at a wind velocity of 4 m/s in a wind direction shown by arrows in FIG. 10 by a blower, not shown, from a position at a distance of 1000 mm. Under this condition, a temperature increase of each of H1 and H2 was measured under a room temperature environment. The results of the analysis described above are shown in Fig. 11.

Note that, the room temperature environmental as used herein means a condition of 20 °C. The temperature increase in H1 and H2 is defined as a temperature after coming to a steady-state from the start-up of the cooling apparatus. For example, in the present example, after an elapse of about 20 to 40 minutes.

Based on the above, a temperature-increase under the room temperature environment will be described with reference to FIG. 11.

With the conventional cooling apparatus 1, an increase in the temperature of H1 at an upstream side was 23.9 °C, and an increase in the temperature of H2 at a downstream side was 23.2 °C.

With the cooling apparatus 10 in the first embodiment, an increase in the temperature of H1 at an upstream side was 20.9 °C, and an increase in the temperature of H2 at a downstream side was 21.7 °C.

With the cooling apparatus 20 in the second embodiment, an increase in the temperature of H1 at an upstream side was 21.5 °C, and an increase in the temperature of H2 at a downstream side was 22.5 °C.

With the cooling apparatus 30 in the third embodiment, an increase in the temperature of H1 at an upstream side was 21.5 °C, and an increase in the temperature of H2 at a downstream side was 22.5 °C.

As can be seen from these results, an improvement of cooling capacity of 13% to 6% is achieved in the first embodiment and 10% to 3% is achieved in the second and third embodiments, as compared to the prior art.

### List of Reference Signs

- 1, 10, 20, 30: cooling apparatus
- 2: heat receiving block
- 21: elongated groove
- 3: heat pipe
- 31: long HP
- 32: short HP
- 33: bent portion
- 34: straight portion
- 4: fin
- 41: first fin group
- 42: second fin group
- 43: third fin group
- 44: fourth fin group
- 5, 50: pin
- 6: elliptic cylindrical member
- B: hole
- B1, B2, B3, B4: burring portion
- H1, H2: electronic component

## Claims

1. A cooling apparatus comprising:
a heat receiving block that is thermally connected to a heating element;
a heat pipe that is provided to stand on a surface of the heat receiving block, the heat pipe being configured to receive heat from the heat receiving block and to transport the heat; and
a plurality of fins attached to the heat pipe,
the heat pipe including a bent portion provided near the heat receiving block and a straight portion formed linearly from the bent portion in a direction away from the heat receiving block,
the fins including a first fin group disposed at the straight portion and a second fin group disposed at the bent portion,
each fin of the second fin group being provided with a hole having an area equivalent to or greater than a cross section of the bent portion and being thermally connected to the heat receiving block by a connecting member that secures the second fin group to the heat receiving block.

2. The cooling apparatus according to claim 1, wherein at least one fin in the first fin group is thermally connected to the heat receiving block by the connecting member.

3. The cooling apparatus according to claim 1, wherein the connecting member is interposed between an outer periphery of the bent portion and an inner periphery of the hole to thermally connect the heat pipe and the second fin group.

4. The cooling apparatus according to claim 3, wherein
the hole of the second fin group has an elliptical shape, and
the connecting member is an elliptic cylindrical body having an outer periphery of substantially the same size as the elliptical shape of the hole and an inner periphery of substantially the same size as an outer periphery of the heat pipe.

5. The cooling apparatus according to claim 3 or 4, wherein
the hole of the second fin group is burred, and
the second fin group being thermally connected to the connecting member and to the heat pipe wider than a thickness of the fin.
